# EUROPEAN PATENT APPLICATION

(11) **EP 4 455 782 A1**
(43) Date of publication of application: **30.10.2024**
(21) Application number: 23169510.7
(22) Date of filing: 24.04.2023
(51) Int. Cl.: G03F 7/00, H01L 21/68

(54) **EXPOSURE APPARATUS AND METROLOGY MEASUREMENT SYSTEM**

(71) Applicant: ASML Netherlands B.V., 5500 AH Veldhoven (NL)
(72) Inventor: GOMMANS, Thomas, Martinus, Petrus, Veldhoven (NL); TER HUURNE, Tim, Gerardus, Hendrikus, Veldhoven (NL)
(74) Representative: ASML Netherlands B.V.

(57) **Abstract**

An exposure apparatus comprises a first structure extending in a second direction and a first actuator to move the first structure in a first direction and a second structure extending in the first direction and a second actuator configured to move the second structure in the second direction, the second direction being substantially perpendicularly to the first direction. A first and a second substrate table are connected to the first and second structures. The first actuator is configured to rotate the first structure around a third direction to determine a rotation of the first substrate table around the third direction, the third direction being substantially perpendicular to the first and to the second direction. The second actuator is configured to rotate the second structure around the third direction to determine a rotation of the second substrate table around the third direction.

## Description

### FIELD

The present invention relates to an exposure apparatus, a metrology measurement system comprising such exposure apparatus and to a lithographic apparatus comprising such exposure apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer).

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus, which uses extreme ultraviolet (EUV) radiation, having a wavelength within a range of 4 nm to 20 nm, for example 6.7 nm or 13.5 nm, may be used to form smaller features on a substrate than a lithographic apparatus which uses, for example, radiation with a wavelength of 193 nm.

Metrology tools are used in many aspects of the IC manufacturing process, for example as alignment tools for proper positioning of a substrate prior to an exposure and scatterometry based tools for inspecting/measuring the exposed and/or etched product in process control; e.g., to measure overlay.

In a lithographic apparatus, and/or in a metrology measurement system, use may be made of a substrate table configured to hold a substrate. A substrate may be loaded on the substrate table. The substrate table may move the substrate, e.g. in a horizontal direction, so as to enable specific parts of a surface of the substrate to be measured by the metrology measurement system or exposed by the lithographic apparatus. Upon loading the substrate on the substrate table, a position of the substrate may be measured, e.g. using an alignment optical sensor. The alignment optical sensor may provide a position measurement in x and y direction, whereby x and y may be defined as the perpendicular directions spanning an e.g. horizontal plane, substantially parallel to the surface of the substrate. Making use of measurement results obtained from alignment measurements in x and y direction, the position of the substrate table in the x direction and in the y direction may be corrected.

When loading the substrate on the substrate table, a rotational position error may result. The rotational position error may require to statically rotate the substrate to some extent in order to compensate the rotational position error. The statical rotation of the substrate table may require to provide a correction of the position of the substrate table in horizontal direction, in order to at least partly compensate for the rotation of the substrate table. In case the substrate table is rotated in the horizontal plane about the centre of the substrate, the correction may be position dependent: the further from a centre of the substrate, the larger an effect of the rotational position error may be, the more correction may be required.

### SUMMARY

The invention aims to provide an improved lithographic apparatus and/or metrology measurement system.

According to an aspect of the invention, there is provided an exposure apparatus comprising
- a first substrate table and a second substrate table;
- a first structure and a first actuator configured to move the first structure in a first direction, the first structure extending in a second direction, and
- a second structure and a second actuator configured to move the second structure in the second direction, the second structure extending in the first direction, the second direction being substantially perpendicularly to the first direction;
- the first substrate table connected to the first structure and to the second structure, the second substrate table connected to the first structure and to the second structure;
- wherein the first actuator is further configured to rotate the first structure around a third direction and wherein the first structure is connected to the first substrate table to determine a rotation of the first substrate table around the third direction, the third direction being substantially perpendicular to the first and to the second direction;
- wherein the second actuator is further configured to rotate the second structure around the third direction and wherein the second structure is connected to the second substrate table to determine a rotation of the second substrate table around the third direction.

According to another aspect of the invention, there is provided a metrology measurement system comprising the exposure apparatus according to an aspect of the invention.

According to yet another aspect of the invention, there is provided a lithographic apparatus configured to project a pattern on a substrate, comprising the exposure apparatus according to an aspect of the invention.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a schematic overview of a scatterometry apparatus used as a metrology device, for use in methods according to embodiments of the invention;
- Figure 3 comprises (a) a schematic diagram of a dark field scatterometer for use in methods according to embodiments of the invention using a first pair of illumination apertures, (b) a detail of diffraction spectrum of a target grating for a given direction of illumination (c) a second pair of illumination apertures providing further illumination modes in using the scatterometer for diffraction based overlay measurements and (d) a third pair of illumination apertures combining the first and second pair of apertures;
- Figure 4 depicts an embodiment of a substrate support, e.g. a wafer table WT of an exposure apparatus
   Figure 5 depicts another embodiment of a substrate support, e.g. a wafer table WT of an exposure apparatus;
- Figure 6 depicts yet another embodiment of a substrate support, e.g. a wafer table WT of an exposure apparatus according to the invention;
- Figure 7 depicts a further embodiment of a substrate support, e.g. a wafer table WT of an exposure apparatus according to the invention.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

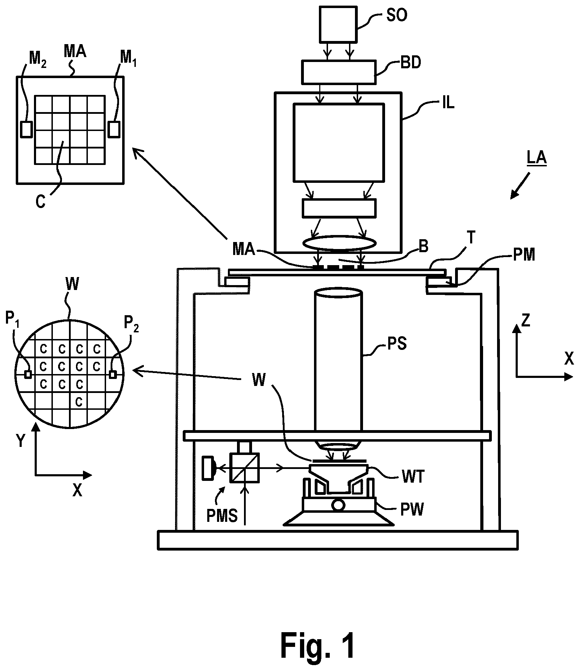

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

To clarify the invention, a Cartesian coordinate system is used. The Cartesian coordinate system has three axis, i.e., an x-axis, a y-axis and a z-axis. Each of the three axis is orthogonal to the other two axis. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is a ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and not yet published US patent application 15/181,126, incorporated herein by reference in its entirety.

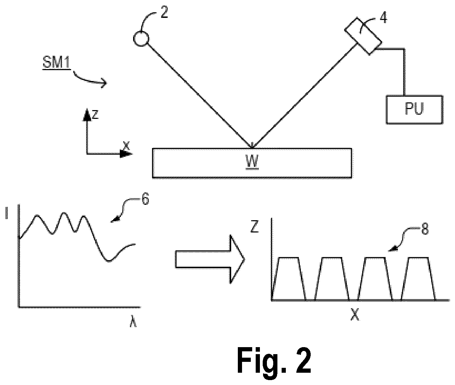

A metrology apparatus, such as a scatterometer, is depicted in Figure 2. It comprises a broadband (white light) radiation projector 2 which projects radiation onto a substrate W. The reflected or scattered radiation is passed to a spectrometer detector 4, which measures a spectrum 6 (i.e. a measurement of intensity as a function of wavelength) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 2. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

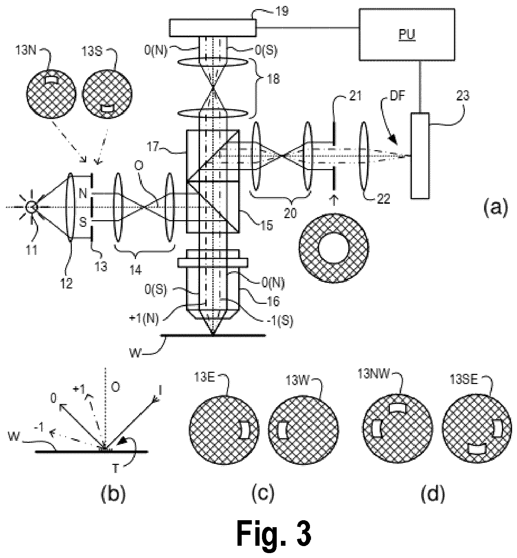

Figure 3(a) presents an embodiment of a metrology apparatus and, more specifically, a dark field scatterometer. A target T and diffracted rays of measurement radiation used to illuminate the target are illustrated in more detail in Figure 3(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the illumination angles can be designed or adjusted so that the first order rays entering the objective lens are closely aligned with the central optical axis. The rays illustrated in Figure 3(a) and 3(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 3(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

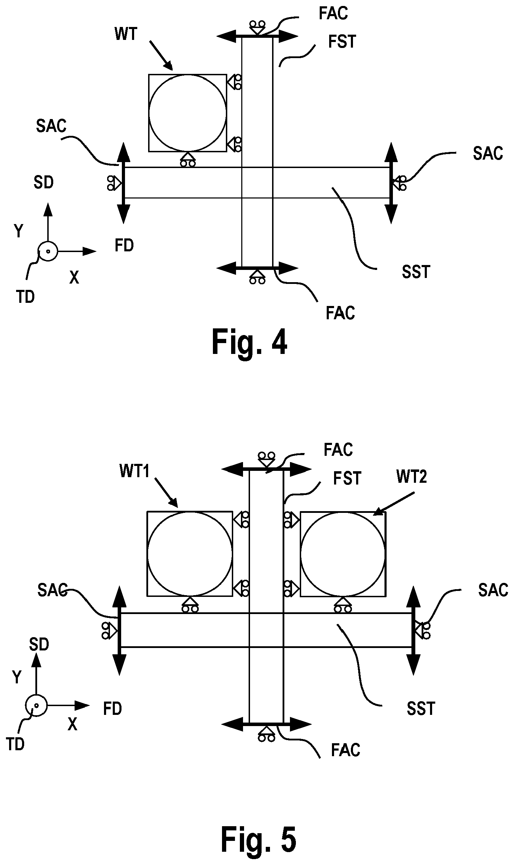

The particular forms of aperture plate 13 and field stop 21 shown in Figure 3 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 5) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 3(c) and (d). The use of these, and numerous other variations and applications of the apparatus are described in prior published applications, mentioned above.

Figure 4 depicts a highly schematic top view of a substrate support, e.g. a wafer table WT of an exposure apparatus. The substrate support, which may also be identified as a substrate table, is positioned by a first structure FST that extends in a second direction SD and by a second structure SST that extends in a first direction FD. The exposure apparatus further comprises a first actuator FAC which is configured to move the first structure in the first direction and a second actuator SAC which is configured to move the second structure in the second direction. The first and second directions in the present example extend in a horizontal plane, i.e. in a plane substantially parallel to the top surface of the substate when held by the substrate table. The first and second directions may further form a plane of movement in which the substrate table may be moved by the actuators. The first direction and second directions may be perpendicular to each other. For example, the first direction may be the x direction and the second direction may be the y direction. In another example, the first direction may be the y direction and the second direction may be the x direction. A third direction TD may be defined as being perpendicular to the plane of drawing. The first and second structures may be separate structures that are movable in respect of each other by the first and second actuators, respectively, i.e. the first and second structures may not be fixedly connected to each other.

The substrate table WT is connected to the first structure and to the second structure so as to be moved as the respective structure is moved by the respective actuator. In the present example, the substrate table is connected to the first structure by dual couplings and to the second structure by a single coupling. The dual couplings are spaced apart in the second direction. As the first structure is moved in the first direction by the first actuator, the dual couplings transfer the actuator force by the first actuator onto the substrate table so as to move the substrate table in the first direction. As the second structure is moved in the second direction by the second actuator, the coupling transfer the actuator force by the second actuator onto the substrate table so as to move the substrate table in the second direction. The first actuator may comprise dual first actuator elements, one on each end of the first structure. The first actuator may thereby be configured to rotate the first structure around the third direction, i.e. around the direction perpendicular to the plane of drawing of Figure 4. As a result of the dual couplings, the substrate table is rotated with the rotation of the first structure. The couplings may be hinges. As the substrate table is connected to the second structure by a single coupling, the substrate table may rotate around the third direction in respect of the second structure.

Figure 5 depicts another embodiment of an exposure apparatus, in the present embodiment comprising dual substrate tables, namely a first substate table and a second substrate table. Both substrate tables are connected to the first structure and to the second structure so as to enable the movements of the substrate tables by movement of the first and second structures. Similarly to Figure 4, the first substrate table WT is connected to the first structure and to the second structure so as to be moved as the respective structure is moved by the respective actuator. In the present example, the first substrate table is connected to the first structure by dual couplings and to the second structure by a single coupling. The dual couplings are spaced apart in the first direction. As the first structure is moved in the first direction by the first actuator, the couplings transfer the actuator force by the first actuator onto the first substrate table so as to move the first substrate table in the first direction. As the second structure is moved in the second direction by the second actuator, the coupling transfers the actuator force by the second actuator onto the first substrate table so as to move the first substrate table in the second direction. As a result of the dual couplings, the first substrate table is rotated with the rotation of the first structure. The couplings may be hinges. As the first substrate table is connected to the second structure by a single coupling, the first substrate table may rotate around the third direction in respect of the second structure.

The second substrate table WT is connected to the first structure and to the second structure so as to be moved as the respective structure is moved by the respective actuator. In the present example, the second substrate table is connected to the first structure by dual couplings and to the second structure by a single coupling. The dual couplings are spaced apart in the second direction. As the first structure is moved in the first direction by the first actuator, the dual couplings transfer the actuator force by the first actuator onto the second substrate table so as to move the second substrate table in the first direction. As the second structure is moved in the second direction by the second actuator, the coupling transfers the actuator force by the second actuator onto the second substrate table so as to move the second substrate table in the second direction. As a result of the dual couplings, the second substrate table is rotated with the rotation of the first structure. The couplings may be hinges, i.e. the dual couplings may be dual hinges. As the second substrate table is connected to the second structure by a single coupling, such as a single hinge, the second substrate table may rotate around the third direction in respect of the second structure. In an embodiment, dual couplings between the first and second substrate tables and the second structure may also be possible, which may provide that the first and second substrate tables are rotated with the rotation of the second structure. The double coupling of the two substrate tables onto the same one of the first and second structures provides for a coupled rotation of the two substrate tables around the third direction.

A problem associated with the embodiment described with reference to Figure 5, is that a rotational position error of the substrate loaded onto the first substrate table and the substrate loaded onto the second substrate table may differ. However, a rotation of - in the present example - the first structure may result in a rotation of both the first and the second substrate table. As a result, adjustment of the rotations around the third direction for each substrate table individually is not possible with the design depicted and described with reference to Figure 5.

The exposure apparatus may comprise two sensors, one per substrate table, in order to enable the exposure apparatus to perform measurements on both substrates simultaneously. Due to misalignment in placement of substrates on the substrate table (due to the substrate pre-alignment module positioning accuracy), both the first substrate held by the first substrate table and the second substrate held by the second substrate table may have independent alignment errors in the first direction, second direction and around the third direction. Consequently, to align two marks (one on each wafer) simultaneously, one of the two sensors requires a two degree of freedom (first and second direction) stage, or each sensor requires one degree of freedom (one in the first direction, the other in the second direction). Alignment errors in first and second direction may be corrected by moving the sensor once per substrate, however as individual substrate table rotation around the third direction is not possible with the embodiment as depicted in Figure 5, the rotation around the third direction may not be compensated for on a once per wafer level and this may lead to a required movement of the sensor in the first and/or second direction for every mark measured. These movements may be required from an alignment perspective however may be undesirable as they require time to settle, which may result in a throughput penalty, cause the actuators to dissipate more energy and lastly the required actuation force to actuate the sensors may cause vibration of a supporting frame, such as a metrology frame.

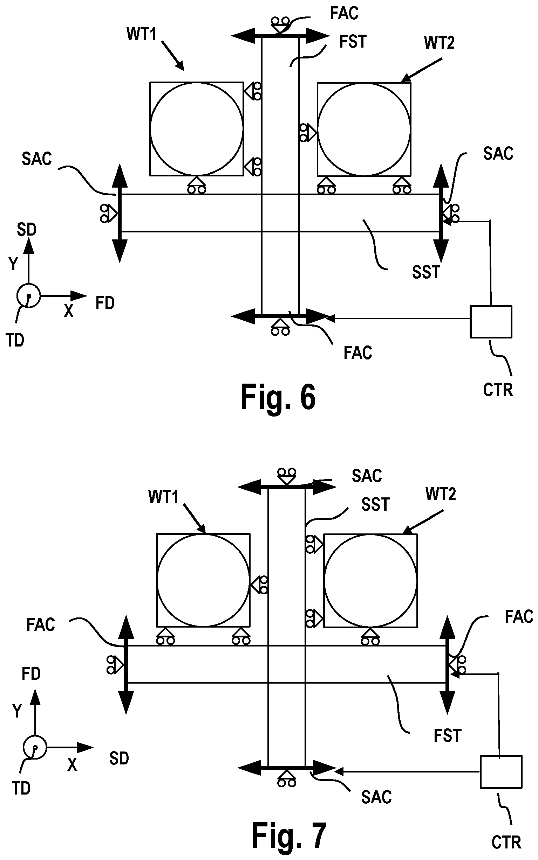

According to the present invention, the first actuator is further configured to rotate the first structure around the third direction. The first structure is connected to the first substrate table to determine a rotation of the first substrate table around the third direction. The second actuator is further configured to rotate the second structure around the third direction and the second structure is connected to the second substrate table to determine a rotation of the second substrate table around the third direction. The third direction is substantially perpendicular to the first direction and to the second direction. Thus, the exposure apparatus is configured to determine the rotation of the first substrate table around the third direction by the first actuator and the first structure and the rotation of second substrate table around the third direction by the second actuator and the second structure (as will be explained in more detail below with reference to Figure 6 and 7).

In a first embodiment, the first direction is the X-direction, whereby the second direction is Y-direction or alternatively, in a second embodiment, the first direction is the Y-direction, whereby the second direction is X-direction. The first embodiment will be described with reference to Figure 6 and the second embodiment will be described with reference to Figure 7.

In general terms, the exposure apparatus comprises a first substrate table and a second substrate table, a first structure extending in a second direction and a first actuator configured to move the first structure in a first direction and a second structure extending in the first direction and a second actuator configured to move the second structure in the second direction, the second direction being substantially perpendicularly to the first direction. The first substrate table is connected to the first structure and to the second structure, the second substrate table connected to the first structure and to the second structure.

The first actuator is further configured to rotate the first structure around the third direction and the first structure is connected to the first substrate table to determine a rotation of the first substrate table around the third direction. The third direction is substantially perpendicular to the first and to the second direction; The second actuator is further configured to rotate the second structure around the third direction and the second structure is connected to the second substrate table to determine a rotation of the second substrate table around the third direction.

In the first embodiment, as depicted in Figure 6, the first direction is the X direction, the second direction is the Y direction and the third direction is the Z direction. The first structure is movable by the first actuator in the X direction and extends in the Y direction and the second structure is movable by the second actuator in the Y direction and extends in the X direction. The Rz rotation of the first substrate table WT1 is determined by the first structure and the Rz rotation of second substrate table WT2 is determined by the second structure.

In the second embodiment, as depicted in Figure 7, the first direction is the Y direction, the second direction is the X direction and the third direction is the Z direction. The first structure is movable by the first actuator in the Y direction and extends in the X direction and the second structure is movable by the second actuator in the X direction and extends in the Y direction. The Rz rotation of the first substrate table WT1 is determined by the first structure and the Rz rotation of second substrate table WT2 is determined by the second structure.

The first actuator FAC is configured to move the first structure FST in the first direction FD and to rotate the first structure around the third direction TD. The first actuator FAC may thereto be provided (e.g. by a controller) with dual input signals, one input signal associated with the movement in the first direction and one input signal associated with the rotation around the third direction. Similarly, the second actuator SAC is configured to move the second structure SST in the second direction SD and to rotate the second structure around the third direction TD. The second actuator may thereto be provided (e.g. by the controller) with dual input signals, one input signal associated with the movement in the second direction and one input signal associated with the rotation around the third direction. The first actuator may for example comprise dual actuator elements, spaced apart in the second direction, e.g. one at each end of the first structure. Actuating both actuator elements in a same way (e.g. by a same actuator drive signal) provides a movement of the first structure in the first direction. Actuating both actuator elements in a opposite way (e.g. by an opposite actuator drive signal) provides a rotation of the first structure around the third direction, e.g. rotating around a center of the first structure between the dual actuator elements. Actuating the actuator elements in other ways (e.g. actuating one actuator element only) provides a rotation of the first structure around the third direction, in the example of actuating one actuator element only, an axis of rotation being more proximate to the non-actuated actuator element.

The second actuator SAC may likewise for example comprise dual actuator elements, spaced apart in the first direction FD, e.g. one at each end of the second structure SST. Actuating both actuator elements in a same way (e.g. by a same actuator drive signal) provides a movement of the second structure in the first direction. Actuating both actuator elements in a opposite way (e.g. by an opposite actuator drive signal) provides a rotation of the second structure around the third direction, e.g. rotating around a center of the second structure between the dual actuator elements. Actuating the actuator elements in other ways (e.g. actuating one actuator element only) provides a rotation of the second structure around the third direction, in the example of actuating one actuator element only, an axis of rotation being more proximate to the non-actuated actuator element.

The first and second structures FST, SST may have any suitable shape, for example the first structure comprises an oblong bar extending in the second direction SD and the second structure comprises an oblong bar extending in the first direction FD.

According to the present invention, individual misalignment in Rz for the first substrate table and for the second substrate table may be corrected without adding additional degrees of freedom. As will be explained in more detail further below, this individual Rz correction allows for a quasi-static sensor stage with a significantly reduced complexity compared to a dynamic sensor stage that is required to perform Rz corrections for every mark measured, as would be the case with, for example, the configuration as described with reference to Figure 5.

In an embodiment, in order to prevent the first structure from rotating the second substrate table and the second structure from rotating the first substrate table, i.e. to support the independent rotation of the substrate tables around the third direction, the first structure is rotatable around the third direction in respect of the second substrate table, i.e. the second substrate table is rotatable around the third direction in respect of the first structure, and the second structure is rotatable around the third direction in respect of the first substrate table, i.e. the first substrate table is rotatable around the third direction in respect of the second structure.

For example, as depicted in Figures 6 and 7, the exposure apparatus comprises two hinges pivotable in the third direction, wherein the first structure is connected to the second substrate table by one of the hinges and the second structure is connected to the first substrate table by the other one of the hinges.

In an embodiment, in order to accurately transfer a rotation of the first structure onto the first substrate table and a rotation of the second structure onto the second substrate table, the first substrate table is connected to the first structure at two locations spaced apart in the second direction, and the second substrate table is connected to the second structure at two locations spaced apart in the first direction. The connections by which the first structure is connected to the first substrate table are stiff in the first direction to accurately transfer the movement in the first direction from the first structure to the first substrate table and the connections by which the second structure is connected to the second substrate table is stiff in the second direction to accurately transfer the movement in the second direction from the second structure to the second substrate table. Instead of the connections at two locations, use may be made of a single, stiff connection or any other stiff connection between the first structure and the first substrate table respectively between the second structure and the second substrate table, capable of transferring a rotation of the respective structure around the third direction to the respective substrate table. The single stiff connection is stiff in the first respectively the second direction (equivalent to the stiff direction for the dual connections), and moreover is stiff around the third direction. (In the dual connection configuration, this stiffness around third direction follows from the two hinges stiff in first/second and spaced apart in second/first).

By contrast, the first structure is connected to the second substrate table at one location, and the second structure is connected to the first substrate table at one location.

For example, as depicted in Figure 6, the exposure apparatus comprises further hinges, wherein the first structure FST is connected to the first substrate table WT1 by a respective pair of the further hinges spaced apart in the second direction SD, and the second structure SST is connected to the second substrate table WT2 by a respective pair of the further hinges spaced apart in the first direction.

For example, the one of the hinges by which the first structure is connected to the second substrate table is stiff in the first direction to accurately transfer the movement in the first direction from the first structure to the second substrate table and the other one of the hinges by which the second structure is connected to the first substrate table is stiff in the second direction to accurately transfer the movement in the second direction from the second structure to the first substrate table.

In an embodiment, the first and second directions span a plane of movement of the substrate table, the plane of movement being substantially parallel to the substrate loading surface of the substrate table, on which the substrate is loaded. Accordingly, the first and second direction may be substantially parallel to a substrate loading surface of the substrate table.

In an embodiment, the first and the second substrate table are arranged, seen in the third direction, at one longitudinal side of one of the first and second structures and wherein the first and the second substrate table are arranged, seen in the third direction, at opposite longitudinal sides of the other one of the first and second structures. An example is depicted in Figures 6. In the embodiment depicted in Figure 6, the first and the second substrate table are arranged, seen in the third direction, at one longitudinal side of the second structure and at opposite longitudinal sides of the first structure. Thereby, a relatively compact arrangement of the substrate tables may be provided whereby the substrate tables are - seen in for example the x-direction - adjacent to each other.

In another embodiment, the first and second substrate table are above the first structure, i.e. spaced apart in the third direction in respect of the first structure.

In yet another embodiment, the first substrate table is arranged on one longitudinal side of the first structure, the second substrate table on the other longitudinal side of the first structure, and the first substrate table on one longitudinal side of the second structure, the second substrate table on the other longitudinal side of the second structure.

As another example, as depicted in Figure 7, the exposure apparatus comprises further hinges, wherein the first structure FST is connected to the first substrate table WT1 by a respective pair of the further hinges spaced apart in the second direction SD, and the second structure SST is connected to the second substrate table WT2 by a respective pair of the further hinges spaced apart in the first direction FD.

For example, the one of the hinges by which the first structure is connected to the second substrate table is stiff in the first direction to accurately transfer the movement in the first direction from the first structure to the second substrate table and the other one of the hinges by which the second structure is connected to the first substrate table is stiff in the second direction to accurately transfer the movement in the second direction from the second structure to the first substrate table.

In an embodiment, the first and second directions span a plane of movement of the substrate table, the plane of movement being substantially parallel to the substrate loading surface of the substrate table, on which the substrate is loaded. Accordingly, the first and second direction may be substantially parallel to a substrate loading surface of the substrate table.

In an embodiment, the first and the second substrate table are arranged, seen in the third direction, at one longitudinal side of one of the first and second structures and wherein the first and the second substrate table are arranged, seen in the third direction, at opposite longitudinal sides of the other one of the first and second structures. An example is depicted in Figure 7. In the embodiment depicted in Figure 7, the first and the second substrate table are arranged at one longitudinal side of the first structure and at opposite longitudinal sides of the second structure. Thereby, a relatively compact arrangement of the substrate tables may be provided whereby the substrate tables are - seen in for example the x-direction - adjacent to each other.

In another embodiment, the first and second substrate table are above the first structure, i.e. spaced apart in the third direction in respect of the first structure.

In yet another embodiment, the first substrate table is arranged on one longitudinal side of the first structure, the second substrate table on the other longitudinal side of the first structure, and the first substrate table on one longitudinal side of the second structure, the second substrate table on the other longitudinal side of the second structure.

In an embodiment, as depicted in Figures 6 and 7, the exposure apparatus further comprises a controller CTR configured to drive the first actuator to move the first structure and the second actuator to move the second structure. The controller is configured to at least partially compensate a statical rotation of the substrate held by the first substrate table, by driving the first actuator to rotate the first structure around the third direction, and to at least partially compensate a statical rotation of the substrate held by the second substrate table, by driving the second actuator to rotate the second structure around the third direction. Thereby, the controller may independently control a statical rotation of the first substrate table and a statical rotation of the second substrate table, by rotation of the respective one of the first and second structures.

In an embodiment, the exposure apparatus further comprises a first sensor configured to measure a position of a mark on a first substrate held by the first substrate table and a second sensor configured to measure a position of a mark on a second substrate held by the second substrate table. The first sensor and the second sensor may for example each comprise a scatterometer SC1 such as described with reference to Figures 2 and 3. A first scatterometer is arranged above the first substrate table to measure a substrate W held by the first substrate table and a second scatterometer is arranged above the second substrate table to measure a substrate W held by the second substrate table.

Individual X and Y alignment errors can be corrected for by moving the sensor once per wafer. In case the controller is capable of reducing the Rz alignment error to zero, for a substrate, no further sensor movements per alignment mark on the substrate may be required to correct the resulting X and Y misalignment. As a rotational position error is corrected by the rotation of the first structure and the first substrate table respectively by the rotation of the second structure and the second substrate table, an positioning error of the substrate on the substrate table in the first and/or second direction remains, which positioning error may be the same for different alignment marks at different locations on the substrate. Thus, the individual X and Y alignment errors are the X and Y offsets with which the substrate is loaded on the substrate table, whereby the marks on the substrate are shifted by the same offset in X and/or Y direction. By moving the sensor in X direction and/or Y direction once per substrate, this offset in X direction and/or Y direction may be corrected for. Note that indeed the marks are on different X/Y positions on the substrate, but the substrate stages move the wafer with respect to the sensor to measure marks across the substrate surface.

Individual substrate Rz alignment errors, when not (fully) corrected by the substrate table result in an (additional) X and Y offset, however, this offset depends on the position of the mark on the substrate. For example, the further the mark is located from a centre of the substrate, the more the remaining Rz alignment error may affect a position of the mark. Due to the remaining Rz alignment error, this offset can not be corrected by a single sensor movement in X and/or Y direction once per substrate, however may require a sensor movement once per mark (due to the position dependency of the error). Fully compensating individual Rz alignment errors may eliminate the need for this sensor movement per mark, partial compensation may reduce the size of the movement required. Thus, in case the Rz error is reduced, the sensor stages are required to make smaller corrections (with regard to the baseline where the sensor corrects the full Rz alignment error induced shift in X and Y direction).

By not requiring the sensors to move for each mark measured, i.e. requiring the sensor to move once per substrate, or reducing a magnitude of the required corrections once per measurement mark, complexity of the sensor stages may be reduced. Stationary or low dynamic sensor actuators may have lower energy consumption and resulting heat dissipation and may not require the metrology frame to deal with high reaction forces caused by dynamic sensor actuation of the sensor actuators. Moreover, throughput and overlay may be improved. Possible throughput improvements follow from the stationary or low dynamic behavior of the sensor (per measurement mark), which may remove or reduce the need for a settling time budget. Similarly, a stationary or low dynamic sensor stage may benefit overlay measurement quality.

Furthermore, not requiring large dynamic moves per measurement mark may simplify the sensor stage design. It is likely to result in smaller sensor stage volume. Firstly, a smaller move (in a same timespan) may be realized by a less powerful actuator. If movement is required only once per wafer, it may have less impact on throughput and may possibly be done slower and/or by a less powerful actuator. Typically this may mean the actuator may be made smaller, and may moreover result in reduced requirements on the frame stiffness and vibration isolation that is required to deal with the reaction force of the actuator. Combined this may lead to a smaller/less complex sensor stage design.

A rotational position error of the substrate loaded onto the first substrate table may at least partly be corrected by a rotation of the first structure, providing for a rotation of the first substrate table and a rotational position error of the substrate loaded onto the second substrate table may at least partly be corrected by a rotation of the second structure, providing for a rotation of the second substrate table. As a result, after correction of the rotational error, a remaining error in X and Y, i.e. in the first and second directions, may remain, e.g. due to positioning inaccuracy of the substrate on the substrate table in X direction and/or Y direction. As explained above, such errors in X and/or Y direction are substantially the same for each location on the substrate. Reverting to the scatterometer as described with reference to Fig 2 and 3, the errors in X and/or Y direction may be corrected by a movement of the entire scatterometer (from lens 16 to sensors 19 and 23), or by a movement of only lens 16. Accordingly, the exposure apparatus may comprise an actuator configured to move the scatterometer or configured to move the lens 16. The scatterometer may be used for metrology of eg overlay, focus, dose, CD.

In order to move the sensor, such as the scatterometer, the exposure apparatus further comprises a first sensor actuator configured to position the first sensor and a second sensor actuator configured to position the second sensor, wherein the controller is configured to drive the first sensor actuator to offset a position of the first sensor to at least partially compensate a position error of the substrate on the first substrate table in at least one of the first direction and the second direction and to drive the second sensor actuator to offset a position of the second sensor to at least partially compensate a position error of the substrate on the second substrate table in at least one of the first direction and the second direction.

The exposure apparatus as described in the present document may be comprised in a metrology measurement system, and/or in a lithographic apparatus configured to project a pattern on a substrate, such as described with reference to Figure 1.

Further embodiments are disclosed in the subsequent list of numbered clauses:
1. An exposure apparatus comprising
   - a first substrate table and a second substrate table;
   - a first structure and a first actuator configured to move the first structure in a first direction, the first structure extending in a second direction, and
   - a second structure and a second actuator configured to move the second structure in the second direction, the second structure extending in the first direction, the second direction being substantially perpendicularly to the first direction;
   - the first substrate table connected to the first structure and to the second structure, the second substrate table connected to the first structure and to the second structure;
   - wherein the first actuator is further configured to rotate the first structure around a third direction and wherein the first structure is connected to the first substrate table to determine a rotation of the first substrate table around the third direction, the third direction being substantially perpendicular to the first and to the second direction;
   - wherein the second actuator is further configured to rotate the second structure around the third direction and wherein the second structure is connected to the second substrate table to determine a rotation of the second substrate table around the third direction.
2. The exposure apparatus according to clause 1, wherein the first structure is rotatable around the third direction in respect of the second substrate table, and wherein the second structure is rotatable around the third direction in respect of the first substrate table.
3. The exposure apparatus according to clause 1 or 2, wherein the first structure is connected to the first substrate table at two locations spaced apart in the second direction, and the second structure is connected to the second substrate table at two locations spaced apart in the first direction.
4. The exposure apparatus according to clause 3, wherein the first structure is connected to the second substrate table at one location, and the second structure is connected to the first substrate table at one location.
5. The exposure apparatus according to any one of the preceding clauses, comprising two hinges pivotable in the third direction, wherein the first structure is connected to the second substrate table by one of the hinges and the second structure is connected to the first substrate table by the other one of the hinges.
6. The exposure apparatus according to any one of the preceding clauses, comprising further hinges, wherein the first structure is connected to the first substrate table by a respective pair of the further hinges spaced apart in the second direction, and the second structure is connected to the second substrate table by a respective pair of the further hinges spaced apart in the first direction.
7. The exposure apparatus according to clause 5 or 6, wherein the one of the hinges by which the first structure is connected to the second substrate table is stiff in the first direction and the other one of the hinges by which the second structure is connected to the first substrate table is stiff in the second direction.
8. The exposure apparatus according to any one of the preceding clauses, wherein the first and second direction are substantially parallel to a substrate loading surface of the substrate table.
9. The exposure apparatus according to any one of the preceding clauses, wherein the first and the second substrate table are arranged, seen in the third direction, at one longitudinal side of one of the first and second structures and wherein the first and the second substrate table are arranged, seen in the third direction, at opposite longitudinal sides of the other one of the first and second structures
10. The exposure apparatus according to any one of the preceding clauses, further comprising a controller configured to drive the first actuator to move the first structure and the second actuator to move the second structure, the controller being configured to at least partially compensate a statical rotation of the substrate held by the first substrate table, by driving the first actuator to rotate the first structure around the third direction, and to at least partially compensate a statical rotation of the substrate held by the second substrate table, by driving the second actuator to rotate the second structure around the third direction
11. The exposure apparatus according to clause 10, wherein the exposure apparatus further comprises a first sensor configured to measure a position of a mark on a first substrate held by the first substrate table and a second sensor configured to measure a position of a mark on a second substrate held by the second substrate table.
12. The exposure apparatus according to clause 11, wherein the exposure apparatus further comprises a first sensor actuator configured to position the first sensor and a second sensor actuator configured to position the second sensor, wherein the controller is configured to drive the first sensor actuator to offset a position of the first sensor to at least partially compensate a position error of the substrate on the first substrate table in at least one of the first direction and the second direction and to drive the second sensor actuator to offset a position of the second sensor to at least partially compensate a position error of the substrate on the second substrate table in at least one of the first direction and the second direction.
13. A metrology apparatus configured to measure a pattern on a substrate, comprising the exposure apparatus according to any one of clauses 1 - 12.
14. A metrology measurement system comprising the exposure apparatus according to any one of clauses 1 - 12.
15. A lithographic apparatus configured to project a pattern on a substrate, comprising the exposure apparatus according to any one of clauses 1-12.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. An exposure apparatus comprising
- a first substrate table and a second substrate table;
- a first structure and a first actuator configured to move the first structure in a first direction, the first structure extending in a second direction, and
- a second structure and a second actuator configured to move the second structure in the second direction, the second structure extending in the first direction, the second direction being substantially perpendicularly to the first direction;
- the first substrate table connected to the first structure and to the second structure, the second substrate table connected to the first structure and to the second structure;
- wherein the first actuator is further configured to rotate the first structure around a third direction and wherein the first structure is connected to the first substrate table to determine a rotation of the first substrate table around the third direction, the third direction being substantially perpendicular to the first and to the second direction;
- wherein the second actuator is further configured to rotate the second structure around the third direction and wherein the second structure is connected to the second substrate table to determine a rotation of the second substrate table around the third direction.

2. The exposure apparatus according to claim 1, wherein the first structure is rotatable around the third direction in respect of the second substrate table, and wherein the second structure is rotatable around the third direction in respect of the first substrate table.

3. The exposure apparatus according to claim 1 or 2, wherein the first structure is connected to the first substrate table at two locations spaced apart in the second direction, and the second structure is connected to the second substrate table at two locations spaced apart in the first direction.

4. The exposure apparatus according to claim 3, wherein the first structure is connected to the second substrate table at one location, and the second structure is connected to the first substrate table at one location.

5. The exposure apparatus according to any one of the preceding claims, comprising two hinges pivotable in the third direction, wherein the first structure is connected to the second substrate table by one of the hinges and the second structure is connected to the first substrate table by the other one of the hinges.

6. The exposure apparatus according to any one of the preceding claims, comprising further hinges, wherein the first structure is connected to the first substrate table by a respective pair of the further hinges spaced apart in the second direction, and the second structure is connected to the second substrate table by a respective pair of the further hinges spaced apart in the first direction.

7. The exposure apparatus according to claim 5 or 6, wherein the one of the hinges by which the first structure is connected to the second substrate table is stiff in the first direction and the other one of the hinges by which the second structure is connected to the first substrate table is stiff in the second direction.

8. The exposure apparatus according to any one of the preceding claims, wherein the first and second direction are substantially parallel to a substrate loading surface of the substrate table.

9. The exposure apparatus according to any one of the preceding claims, wherein the first and the second substrate table are arranged, seen in the third direction, at one longitudinal side of one of the first and second structures and wherein the first and the second substrate table are arranged, seen in the third direction, at opposite longitudinal sides of the other one of the first and second structures

10. The exposure apparatus according to any one of the preceding claims, further comprising a controller configured to drive the first actuator to move the first structure and the second actuator to move the second structure, the controller being configured to at least partially compensate a statical rotation of the substrate held by the first substrate table, by driving the first actuator to rotate the first structure around the third direction, and to at least partially compensate a statical rotation of the substrate held by the second substrate table, by driving the second actuator to rotate the second structure around the third direction

11. The exposure apparatus according to claim 10, wherein the exposure apparatus further comprises a first sensor configured to measure a position of a mark on a first substrate held by the first substrate table and a second sensor configured to measure a position of a mark on a second substrate held by the second substrate table.

12. The exposure apparatus according to claim 11, wherein the exposure apparatus further comprises a first sensor actuator configured to position the first sensor and a second sensor actuator configured to position the second sensor, wherein the controller is configured to drive the first sensor actuator to offset a position of the first sensor to at least partially compensate a position error of the substrate on the first substrate table in at least one of the first direction and the second direction and to drive the second sensor actuator to offset a position of the second sensor to at least partially compensate a position error of the substrate on the second substrate table in at least one of the first direction and the second direction.

13. A metrology apparatus configured to measure a pattern on a substrate, comprising the exposure apparatus according to any one of claims 1-12.

14. A metrology measurement system comprising the exposure apparatus according to any one of claims 1-12.

15. A lithographic apparatus configured to project a pattern on a substrate, comprising the exposure apparatus according to any one of claims 1-12.
